# EUROPÄISCHE PATENTANMELDUNG

(11) **EP 0 642 078 A2**
(43) Veröffentlichungstag der Anmeldung: **08.03.1995**
(21) Anmeldenummer: 94111940.6
(22) Anmeldetag: 30.07.1994
(51) Int. Cl.: G06F 11/00, G11C 29/00

(54) **Verfahren und Vorrichtung zur Fehlerprüfung und zur Fehlerkorrektur in Speicherbausteinen**

(30) Priorität: 28.08.1993 DE 4329012
(71) Anmelder: Alcatel SEL Aktiengesellschaft, D-70435 Stuttgart (DE); ALCATEL N.V., NL-1077 XX Amsterdam (NL)
(72) Erfinder: Kopp, Dieter, D-71282 Hemmingen (DE)
(74) Vertreter: Knecht, Ulrich Karl

(57) **Zusammenfassung**

Fehlerkorrektur bei digitalen Speicherbausteinen zu jedem Zeitpunkt und mit einfachen Mitteln.

Speicherbaustein wird in Segmente aufgeteilt. Daten werden geschrieben, nach einer Zeitspanne geprüft. Beim Auftreten von einem Fehler werden Korrekturdaten eingetragen. Dieser Vorgang wird wiederholt bis kein Fehler mehr auftritt.

## Beschreibung

Die Erfindung betrifft ein Verfahren und eine Vorrichtung zur Fehlerkorrektur in Speicherbausteinen, insbesondere zur Verwendung zur digitalen Sprachspeicherung.

Bei einer digitalen Sprachspeicherung werden vorzugsweise sogenannte ARAM's (Audio Random-Access Memory) als Speicherbausteine verwendet. Diese sind sogenannte DRAM 's (Dynamic Random-Access memory) mit maximal bis zu 0,2% Fehlern wie vom Hersteller zugesichert wird (Texas Instruments Inc.; 4 Mega Bit ARAM TMA 44 400). Desweiteren gibt es bei diesen Speicherbausteinen einen Bereich der garantiert fehlerfrei ist.

Bisher bekannte Methoden die verbleibenden Fehler festzustellen, arbeiten nach dem folgenden Prinzip. Nach dem Einschalten eines Systems in dem der Speicherbaustein ein Bestandteil ist, wird der Speicherbaustein mittels eines Testprogrammes auf Fehler hin überprüft. Die Adressen der fehlerhaften Bereiche werden festgestellt. Diese Adressen werden dann in einem weiteren Speicher abgelegt. Dieser weitere Speicher ist z.B. ein sogenannter SRAM (Static Random-Access Memory)-Baustein. Die Durchführung dieser Methode dauert ca. 30 Sekunden. Beim Einschreiben von Daten in den Speicherbaustein wird, bevor die Daten endgültig eingeschrieben werden, überprüft ob der Bereich der beschrieben werden soll als fehlerhaft im SRAM verzeichnet ist. Ist der Bereich als fehlerhaft verzeichnet, so wird entweder auf den nächsten Bereich übergegangen oder ein Korrekturwert wird in das SRAM geschrieben.

Beim Auslesen von Daten aus dem Speicherbaustein wird in entsprechender Weise gearbeitet. Mit dieser Methode können aber nur Fehler beim Einschalten des Systems entdeckt werden. Eine Korrektur von Fehlern die beim Einschalten nicht erkannt worden sind ist hiermit nicht möglich.

Eine weitere Möglichkeit wird in der deutschen Patentanmeldung P 42 04 929.6 beschrieben. Hierin wird ein digitales Sprachspeichersystem beschrieben bei dem eine Speichersteuerung vorhanden ist, die in der Lage ist, bleibende Fehler zu erkennen und die erkannten Fehler mit den dazugehörigen Adressen in einem Gesamtverzeichnis zu löschen. Diese Methode ist aber nicht in der Lage die erkannten Fehler zu korrigieren, sondern lediglich eine fehlerhafte Speicherung zu vermeiden.

Eine fehlerfreie Speicherung, d.h. eine Benutzung fehlerhafter Speicherbereiche zu vermeiden, ist für die Speicherung gesprochener Nachrichten von großer Bedeutung. Die Verwendung fehlerhafter Speicherbereiche die insgesamt eine festgelegte Fehlerrate übersteigen würden, würde zu Beeinträchtigungen führen, die entweder bei der Wiedergabe zu unerwünschten, hörbaren Störungen oder gar zu Ausfällen führen würden.

Der Erfindung liegt die Aufgabe zugrunde ein Verfahren und eine Vorrichtung zu entwickeln, mittels dem eine Fehlerprüfung und eine Fehlerkorrektur durchgeführt werden kann.

Die Aufgabe wird gelöst durch die Merkmale des ersten Patentanspruchs und durch die Merkmale des fünften Patentanspruchs.

Ein Vorteil hierbei ist, daß begrenzt vorhandener Speicherplatz mit relativ geringem Aufwand optimal ausgenutzt werden kann. Besonders bei der Sprachspeicherung ist ein großer Speicherplatzbedarf vorhanden, weshalb der vorhandene optimal ausgenutzt werden sollte.

Ein weiterer wichtiger Vorteil ist, daß die vorhandenen Fehler nicht nur zum Zeitpunkt der Inbetriebnahme gesucht werden, sondern auch daß während dem Einschreiben von Daten vorhandene Fehler noch entdeckt werden können. Dies erhöht die Fehlererkennungsrate und somit die Sicherheit vor unerwünschten Störungen beträchtlich.

Vorteilhafte Ausgestaltungen der Erfindung sind den Ansprüchen 2 bis 4 und den Ansprüchen 6 bis 8 zu entnehmen.

Nach Anspruch 2 wird ein Fehlerzähler zur Zählung der Einzelfehler vorgesehen. Beim Überschreiten einer beliebig festgelegten Fehleranzahl kann damit ein Fehler als zu stark fehlerbehaftet ausgesondert werden, was die Sicherheit vor unerwünschten Störungen oder gar Ausfällen weiter erhöht.

Nach Anspruch 3 wird eine besonders vorteilhafte Ausgestaltung der einzelnen Segmente erläutert.

Nach Anspruch 4 wird eine Möglichkeit mit der die Daten ausgelesen werden können erläutert. Durch Kenntnis der Fehleranzahl ist es möglich zu berechnen und somit zu erkennen in welchem Bereich die Daten eingeschrieben worden sind.

Nach Anspruch 6 werden die zu dem zuvor erläuterten Verfahren entsprechenden Mittel beansprucht.

Anspruch 7 gibt eine vorteilhafte Verwendung des beanspruchten Verfahrens zur Sprachspeicherung in digitalen Anrufbeantwortern an.

Nach Anspruch 8 kann eine vorteilhafte Verwendung in Telekommunikationsendgeräten zum Tragen kommen. Besondere Anwendung findet das bei der Bild-, Text- oder Sprachkommunikation.

Im folgenden wird die Erfindung anhand der Figuren und des Diagrammes erläutert. Folgende Figuren zeigen:
- Fig. 1:: Ablaufdiagramm des erfindungsgemäßen Verfahrens,
- Fig. 2:: Schematische Darstellung eines Speicherbausteins,
- Diagramm 1:: Darstellung eines Segmentes.

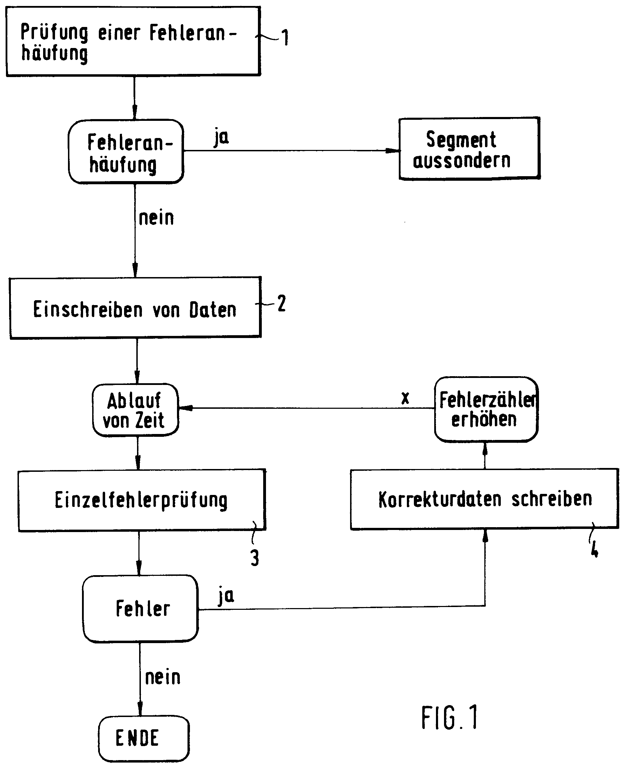

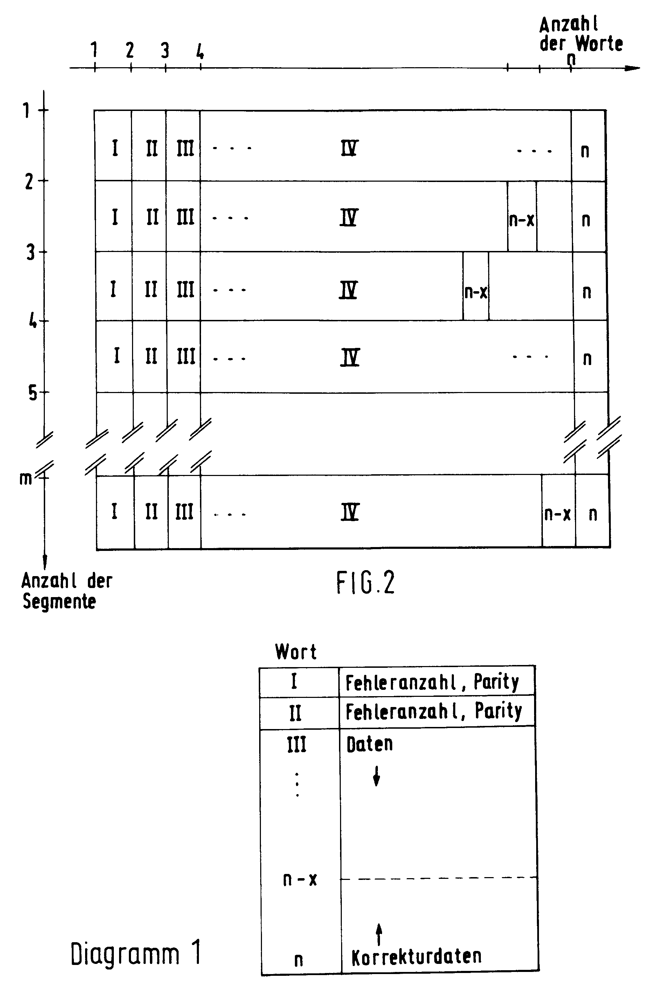

Im folgenden Teil wird das Verfahren nach Anspruch 1 anhand von Figur 1 erläutert und entsprechend die Vorrichtung nach Anspruch 4. In einem Verfahren zur Fehlerkorrektur in Speicherbausteinen, wie z.B. in den als ARAM (Audio Random-Access Memory) bezeichneten Halbleiterbausteinen, wird der Speicherbaustein in Segmente aufgeteilt. Die Segmente bestehen, wie später anhand von Figur 2 noch eingehend erläutert wird, aus einer festgelegten Anzahl von Worten, auch Bits genannt.

Bevor Daten in den Speicherbaustein eingeschrieben werden, wird eine Prüfung einer Fehleranhäufung vorgenommen. Mittels eines ersten Mittels (1) zum Durchführen eines Speichertestes zur Erkennung einer Fehleranhäufung wird diese einfache Prüfung durchgeführt, und für den Fall, daß eine Fehleranhäufung festgestellt wird, wird das entsprechende Segment nicht für die Speicherung von Daten verwendet und ausgesondert.

Für den Fall, daß keine Fehleranhäufung auftritt wird das Verfahren weitergeführt und Daten werden in den Speicherbaustein eingeschrieben. Dies erfolgt mittels Schreib- und Lesemitteln 2.

Nachdem das Einschreiben der Daten beendet ist, wird eine festgelegte Zeitspanne lang gewartet und danach findet eine Einzelfehlerprüfung statt. Dies erfolgt mittels zweiter Mittel 3 zum Durchführen eines Speichertests zur Erkennung von Einzelfehlern, bei der ebenfalls geprüft wird, ob die Daten eingeschrieben sind.

Zur Erkennung von Einzelfehlern werden die Daten des Segmentes überprüft. Die Daten werden gelesen und mittels der später noch genauer erläuterten Methode kann genau festgestellt werden wo sich Korrekturdaten und wo sich die Daten, wie z.B. Sprachdaten befinden.

Für den Fall, daß ein Einzelfehler in einem Segment festgestellt wird, werden Korrekturdaten in das fehlerhafte Segment des Speicherbausteins geschrieben. Dies erfolgt ebenfalls mittels Schreibmitteln 4 zum Schreiben von Korrekturdaten. Bei jedem auftretenden und festgestellten Fehler wird ein Fehlerzähler um eins erhöht. Der Fehlerzähler gibt also die absolute Fehleranzahl eines Speichersegmentes an.

Danach wird wieder der bereits zuvor erläuterte Ablauf wiederholt, indem wieder eine Zeitspanne lang bis zur nächsten Einzelfehlerprüfung gewartet wird.

Dieser Kreislauf wird so lange wiederholt, bis kein Einzelfehler mehr festgestellt wird. Tritt kein Fehler mehr auf, wird das Verfahren zur Fehlerkorrektur beendet.

Die zuvor beschriebenen Schreib- und Lesemittel 2 sind neben der bereits beschriebenen Funktion des Schreibens von Daten in die Speicherbausteine auch in der Lage, Daten aus dem Speicherbaustein herauszulesen und diese beipielsweise an eine Ausgabeeinheit weiterzugeben.

Im folgenden Teil wird anhand von Figur 2 und anhand von Diagramm 1 die Aufteilung des Speicherbausteins beschrieben.

Der Speicherbaustein, beispielsweise ein ARAM, wird in Segmente aufgeteilt. Die Anzahl der Segmente m ist variabel. Jedes Segment wiederum wird in eine festgelegte Anzahl aus n Worten unterteilt. Entsprechend der Anzahl n der Worte und der gesamten Speicherbausteingröße ergibt sich die Anzahl m der Segmente. Vorteilhaft erweist sich die Aufteilung in Segmente von 512 Byte pro Segment, wenn die gesamte Speicherbausteingröße 4 Mbit beträgt.

Ein Segment setzt sich aus n Worten zusammen, wobei die Verwendung jedes einzelnen Wortes aus Diagramm 1 zu ersehen ist. Das erste Wort I nimmt die Fehleranzahl x auf. Ebenso das zweite Wort II eines jeden Segmentes.

Ab dem dritten Wort können Daten in das Segment geschrieben werden. Dies entspricht den Bereichen III und IV.

Von dem letzten Wort n ausgehend in Richtung zum Segmentanfang hin werden die Korrekturdaten in das Segment eingeschrieben.

Daraus ergibt sich der Übergang zwischen den Daten und den Korrekturdaten variabel zu einem Wert von n-x, wobei x einer ganzen Zahl größer oder gleich 0 entspricht.

Der Wert des Übergangs n-x kann, abhängig von der Fehleranzahl x, für jedes Segment 1 bis m unterschiedlich sein.

Die in dem ersten und dem zweiten Wort I und II eingetragene Fehleranzahl ist durch Parität geschützt.

Die vorteilhafte Verwendung dieser Segmentstruktur, der daraus resultierenden Speicherbausteinaufteilung und die Verwendung des Verfahrens zur Fehlerkorrektur zeigt sich folgendermaßen:

Beim Lesen der Daten wird das ganze Segment gelesen. Mit der in dem ersten und dem zweiten Wort enthaltenen Fehleranzahl x kann errechnet werden in welchem Bereich Daten und in welchem Bereich Korrekturdaten eingetragen sind.

Wird zum Beispiel eine Korrektur ausgeführt, kann anhand der Fehleranzahl und der Berechnung ermittelt werden, wo genau die Korrekturdaten einzutragen sind, da diese wie bereits beschrieben von Wort n aus in Richtung Wort 1 hin, eingetragen werden.

Mit diesen Kenntnissen kann eine Korrektur der Daten während des Lesens vorgenommen werden. Die zuvor beschriebenen Verfahrensschritte und die Vorrichtung können vorteilhaft zur Speicherung digitaler Sprachdaten zum Beispiel bei einem Anrufbeantworter verwendet werden.

Bei der Speicherung von digitalen Sprachdaten in einem Anrufbeantworter werden Referenzdaten die eine Art Inhaltsverzeichnis darstellen, abgespeichert. Die Referenzdaten geben den Tag und die Zeit der Speicherung einer Nachricht und somit auch des Aufsprechens der Nachricht an. Desweiteren muß festgestellt werden können, ab welchem Bereich im Speicher eine neue Nachricht gespeichert ist. Diese Referenzdaten können entweder wie die Sprachdaten abgelegt werden, oder aber sie werden in einem garantiert fehlersicheren Bereich abgelegt. Dieser garantiert fehlersichere Bereich wird vom Hersteller von Halbleiterbausteinen garantiert. Alle diese Daten werden ebenfalls mit Parität geschrieben und auch diese Daten werden nach Ablauf einer Zeitspanne auf Fehler hin überprüft.

In dem als fehlerfrei garantierten Bereich werden die Korrekturdaten in Form von Adresse des Fehlers plus Korrekturdaten geschrieben.

Das zuvor erläuterte Verfahren und die Vorrichtung findet eine vorteilhafte Verwendung nicht nur bei der Speicherung von Sprachdaten sondern auch bei der Speicherung von Bild- und Textdaten, wobei ein wie bereits vorher erwähnter Speicherbaustein wie zum Beispiel ein ARAM oder auch ein DRAM verwendet wird.

## Patentansprüche

1. Verfahren zur Fehlerprüfung und zur Fehlerkorrektur in Speicherbausteinen bei dem die Speicherbausteine in Segmente aufgeteilt werden,
bei dem vor einem Einschreiben von Daten eine Fehleranhäufung mittels eines Speichertests erkannt wird,
und bei dem Auftreten einer Fehleranhäufung das Segment nicht mehr zu einer Speicherung verwendet wird,
bei dem nach dem Einschreiben von Daten nach Ablauf einer Zeitspanne jedes Segment auf Einzelfehler hin überprüft wird,
und bei einem Auftreten eines Einzelfehlers Korrekturdaten in das Segment geschrieben werden,
und bei dem diese Einzelfehlerprüfung so lange wiederholt wird bis kein Fehler mehr auftritt.

2. Verfahren nach Anspruch 1, bei dem bei dem Auftreten eines Einzelfehlers ein Fehlerzähler um Eins erhöht wird, und bei dem beim Überschreiten des Fehlerzählers von einer festgelegten Anzahl, das Segment nicht mehr zu einer Speicherung verwendet wird.

3. Verfahren nach Anspruch 1 oder 2,
bei dem jedes Segment in eine Vielzahl von Worten aufgeteilt wird,
bei dem als die ersten beiden Worte jedes Segmentes die Fehleranzahl eingetragen wird,
bei dem ab dem dritten Wort die Daten eingeschrieben werden,
bei dem von dem letzten Wort jedes Segmentes aus die Korrekturdaten in Richtung des ersten Wertes eingeschrieben werden.

4. Verfahren nach Anspruch 3,
bei dem zur Ausführung der Korrektur die Daten jedes Segmentes als Ganzes gelesen werden,
und aus der in den ersten beiden Worten enthaltenen Fehleranzahl der Bereich in dem die Daten eingeschrieben sind und der Bereich in dem die Korrekturdaten eingeschrieben sind, berechnet wird.

5. Vorrichtung zur Fehlerprüfung und zur Fehlerkorrektur in Speicherbausteinen, bei dem die Speicherbausteine in Segmente aufgeteilt sind, bestehen aus:
- Schreib- und Lesemitteln (2) zum Schreiben und Lesen von Daten in und aus den Segmenten von Speicherbausteinen,
- ersten Mitteln (1) zum Durchführen eines Speichertests zur Erkennung einer Fehleranhäufung
- zweiten Mitteln (3) zum Durchführen eines Speichertests zur Erkennung von Einzelfehlern und
- Schreibmitteln (4) zum Schreiben von Korrekturdaten in die Speicherbausteine.

6. Vorrichtung nach Anspruch 5 mit Berechnungsmitteln zur Berechnung von Bereichen in denen Daten und in denen Korrekturdaten eingetragen sind und mit einem Fehlerzähler zur Zählung der Anzahl der Einzelfehler.

7. Verwendung des Verfahrens nach einem der Ansprüche 1 bis 4 zur Sprachspeicherung in digitalen Anrufbeantwortern.

8. Verwendung des Verfahrens nach einem der Ansprüche 1 bis 4 in Telekommunikationsendgeräten zur Bild-, Text- und Sprachkommunikation.
